Europäisches Patentamt

European Patent Office

Office européen des brevets

(19)

(11) **EP 0 666 335 B1**

(12) **EUROPÄISCHE PATENTSCHRIFT**

(45) Veröffentlichungstag und Bekanntmachung des Hinweises auf die Patenterteilung:
**06.05.1999 Patentblatt 1999/18**

(51) Int Cl.[6]: **C23C 14/00**, C23C 14/32, H01J 37/32

(21) Anmeldenummer: **95100987.7**

(22) Anmeldetag: **25.01.1995**

(54) **Verfahren zum Betreiben eines Vakuumlichtbogenverdampfers und Stromversorgungseinrichtung dafür**

Method for operation of a vacuum arc evaporator and current supply therefor

Méthode de conduite d'opération d'un évaporateur à arc sous vide et sa source de courant

(84) Benannte Vertragsstaaten:
**CH DE FR GB LI NL**

(30) Priorität: **25.01.1994 DE 4401986**

(43) Veröffentlichungstag der Anmeldung:
**09.08.1995 Patentblatt 1995/32**

(73) Patentinhaber: **Grimm, Werner, Dr.**
**01326 Dresden (DE)**

(72) Erfinder:
- **Grimm, Werner**
  **D-01326 Dresden (DE)**
- **Ellrodt, Mario**
  **D-39387 Oschersleben (DE)**

(74) Vertreter: **Pätzelt, Peter, Dipl.-Ing. (FH)**
**Patentanwälte Pätzelt & Seltmann**
**Ammonstrasse 72**
**01067 Dresden (DE)**

(56) Entgegenhaltungen:
**US-A- 5 013 578        US-A- 5 126 163**

- **PATENT ABSTRACTS OF JAPAN vol. 013 no. 233 (C-601) ,29.Mai 1989 & JP-A-01 042574 (NISSIN ELECTRIC CO LTD) 14.Februar 1989,**
- **PATENT ABSTRACTS OF JAPAN vol. 017 no. 409 (C-1091) ,30.Juli 1993 & JP-A-05 078840 (NIPPON STEEL CORP) 30.März 1993,**
- **18TH INTERNATIONAL CONFERENCE ON METALLURGICAL COATINGS AND THIN FILMS, SAN DIEGO, CA, USA, 22-26 APRIL 1991, Bd. 49,Nr. 1-3, ISSN 0257-8972, SURFACE AND COATINGS TECHNOLOGY, 10 DEC. 1991, SWITZERLAND, Seiten 258-262, OLBRICH W ET AL 'Improved control of TiN coating properties using cathodic arc evaporation with a pulsed bias'**
- **SECOND INTERNATIONAL CONFERENCE ON PLASMA SURFACE ENGINEERING, GARMISCH-PARTENKIRCHEN, WEST GERMANY, 10-14 SEPT. 1990, Bd. A140, ISSN 0921-5093, MATERIALS SCIENCE & ENGINEERING A (STRUCTURAL MATERIALS: PROPERTIES, MICROSTRUCTURE AND PROCESSING), 7 JULY 1991, SWITZERLAND, Seiten 830-837, FESSMANN J ET AL 'Cathodic arc deposition of TiN and Zr(C,N) at low substrate temperatures using a pulsed bias voltage'**

**Beschreibung**

Die Erfindung betrifft ein Verfahren zum Betreiben eines Vakuumlichtbogenverdampfers nach dem Oberbegriff des Anspruches 1, insbesondere zur Herstellung dünner und harter homogener Schichten, Mehrfachschichten oder Mischschichten aus leitfähigem Material.

Die plasmagestützte Beschichtung mit einem Vakuumlichtbogenverdampfer, teilweise auch als Vakuumbogenverdampfer oder Lichtbogenverdampfer bezeichnet, hat gegenüber anderen Verfahren wesentliche Vorteile, die zur breiten Anwendung derartiger Verdampfer geführt haben. Insbesondere sind es dabei der relativ einfache konstruktive Aufbau eines Vakuumlichtbogenverdampfers, die einfache Verfahrensführung, die hohe Verdampfungsleistung und die sogenannte kalte Kathode. Der Verdampfer weist kein Schmelzbad auf und er kann innerhalb der Beschichtungskammer frei angeordnet werden. Die Verdampfung von oben nach unten ist ebenso möglich wie die Verdampfung in horizontaler Richtung.

Verfahrenstypisch wird das zu verdampfende Material, welches ein leitfähiges Material sein muß, auf kathodisches Potential gelegt, während als Anode eine spezielle Elektrode vorhanden ist oder es wird die Wand der Beschichtungskammer bzw. andere Einbauten mit dem anodischen Potential einer Stromquelle verbunden. Zur Zündung der Vakuumlichtbogenentladung ist es üblich, mit einem Zündmechanismus das anodische Potential kurzzeitig mit dem kathodischen Target kurzzuschließen, damit ein kleiner Zündlichtbogen entsteht, der ausreicht, daß sich zwischen der eigentlichen Anode und dem Target ein Vakuumlichtbogen ausbildet und selbständig weiterbrennt. Der Vakuumlichtbogen trifft über den sogenannten Kathodenfleck, auch Brennfleck genannt, mit hoher Energiedichte auf das Target auf. Dabei wandert der Kathodenfleck materialabhängig meist mit hoher Geschwindigkeit stochastisch über die Targetoberfläche. Innerhalb des Kathodenflecks, der eine hohe Energiedichte aufweist, erodiert das Material explosionsartig aus der festen Phase. Der dabei entstehende Metalldampf ist in hohem Maße ionisiert.

Nachteilig bei diesem Verdampfungsmechanismus ist, daß es in unmittelbarer Nähe des Kathodenflecks zu Aufschmelzungen kommt und diese Aufschmelzungen als kleine flüssige Tropfen aus der Targetoberfläche herausgeschleudert werden. Diese Tropfen, die sogenannten Droplets, gelangen auch bis an die Substratoberfläche und führen dort zu Störungen im Schichtaufbau. Derartige Schichten sind in vielen Fällen unbrauchbar. Die Verfahrensführung kann somit nur in Arbeitsbereichen erfolgen, in denen die Dropletbildung minimiert ist. Typische Werte dafür sind Ströme zwischen 80 bis 120 A bei 18 bis 22 V Spannungsabfall. Bei kleineren Stromwerten brennt der Vakuumlichtbogen in der Regel instabil und bei höheren Stromwerten steigt die Dropletbildung an. Da die Verdampfungsleistung des Vakuumlichtbogenverdampfers bei konstanten Druckverhältnissen in der Beschichtungskammer bekanntermaßen nur über den Strom geregelt werden kann, ist die vorgenannte Einschränkung sehr nachteilig und die Dampfdichte kann nur in einem sehr schmalen Bereich variiert werden. Nach dem Stand der Technik sind verschiedene Lösungen bekannt, die die Dropletemission verringern sollen. Diese Lösungen haben in der Praxis jedoch keine größere Bedeutung erlangt. Die DE 22 14 590 gibt z. B. eine Lösung an, bei der ein Elektromagnet, der in den Dampfstrom eingebracht wird, eine Minimierung der Droplets bewirkt.

Der beschriebene Verdampfungsmechanismus führt zu einem weiteren Nachteil des Vakuumlichtbogenverdampfers. Die stochastische, unkontrollierte und meist sehr schnelle Bewegung des Kathodenflecks auf der Kathodenoberfläche kann dazu führen, daß der Bogen ausbricht und Isolatoren, Abschirmungen und andere Einbauten in der Nähe der Kathode beschädigt. Um diesem Problem zu begegnen, werden nach dem Stand der Technik am äußeren Rand Begrenzungseinrichtungen aus speziellen Materialien mit niedrigen Elektronenemissionskoeffizienten angeordnet. Nach der DE 33 45 493 wird um das Target ein Ring aus Bornitrid angebracht. Dadurch soll der Kathodenfleck vom Rand des Targets weg in den inneren Bereich getrieben werden. Die Folge ist, daß im Randbereich des Targets nur wenig Material verdampft wird und ein breiter Rand stehen bleibt. Das Target kann oft nur zu 40% ausgenutzt werden und muß relativ zeitig durch ein neues Target eingesetzt werden.

Andere Lösungen, z. B. nach der DE 35 28 677 (siehe auch ROTH/VETTER, Plasmabeschichtungsverfahren und Hartstoffschichten, Deutscher Verlag für Grundstoffindustrie Leipzig, 1992, S. 80 ff), versuchen den Kathodenfleck mittels Magnetfelder zu beeinflussen und zu führen. Mit derartigen technisch aufwendigen Lösungen wird das Target oft wesentlich gleichmäßiger abgetragen, ein unerwünschter größerer Rand des Targets bleibt dennoch stehen und die Ausnutzung des Targets ist weiterhin begrenzt. Nur mit speziellen technischen Lösungen, z. B. mit motorisch geführten Magnetfeldablenkungen kann der Kathodenfleck derart geführt werden, daß bei einigen Targetmaterialien ein relativ gleichmäßiger Abtrag erfolgt.

Die vorgenannte Beschreibung bezieht sich im wesentlichen auf Metalle der Gruppe IVb, Vb und VIb. Insbesondere aber auf das hochrelevante Titan. Bei anderen für Beschichtungszwecke interessante leitende Materialien wie Aluminium und Kohlenstoff treten zusätzliche Probleme auf. Bei Aluminium und Kohlenstoff wandert der Kathodenfleck materialtypisch nur langsam über die Targetoberfläche und er kann sich auch an einem Ort festbrennen. In der Folge entstehen tiefe Erosionsgräben, mit Ausbildung kleiner Schmelzbäder, die erwartungsgemäß in starkem Maße zur Dropletbildung führen, so daß die abgeschiedenen Schichten eine "Apfelsinenschalen-Struktur" aufweisen.

Die Abscheidung von Legierungsschichten mit Vakuumlichtbogenverdampfern kann nach dem Stand der Technik mittels gesinterter oder metallurgisch hergestellter Mischtargets realisiert werden. Die Herstellung solcher Targets ist sehr teuer. Eine andere Lösung ist das Pfropfen einer zweiten Materialkomponente in ein Target aus einem Basismaterial. Der Nachteil der letzteren Variante besteht darin, daß der Kathodenfleck nicht mit Sicherheit und erforderlicher relativer Gleichmäßigkeit über die Oberfläche des Targets gelenkt werden kann. Gewöhnlich wird eine Materialkomponente bevorzugt verdampft oder das Mischungsverhältnis des Dampfstromes wechselt stochastisch. Um diesem Problem zu begegnen, wird nach der EP 0489369 AI vorgeschlagen, die Pfropfen in dem Basismaterial geometrisch auszuformen.

Die Variation der Schicht zusammensetzung innerhalb eines Beschichtungsprozesses ist nach dem Stand der Technik mit nur einem Vakuumlichtbogenverdampfer nicht möglich. Die Legierungsschicht ist immer an die Zusammensetzung des Targets gekoppelt unabhängig davon, daß innerhalb eines Beschichtungsprozesses Variationen mit Gasen, z. B. mit Stickstoff zur Nitridbildung, möglich sind.

Die Aufgabe der Erfindung besteht darin, ein Verfahren nach dem Oberbegriff des Anspruches 1 anzugeben, bei dem mit geringem technischen und ökonomischen Aufwand eine stabile Vakuumlichtbogenentladung auch bei geringen mittleren Strömen aufrechterhalten werden kann und eine im wesentlichen gleichmäßige Abtragung des Targets erfolgt. Die Bewegung des Kathodenfleckes soll derart gesteuert werden können, daß zwei unterschiedliche Einzelmaterialien innerhalb eines Targets gleichmäßig verdampft werden können. Das Verfahren soll weiterhin die Dropletbildung minimieren. Eine weitere Aufgabe besteht darin, eine Einrichtung zur Realisierung des Verfahrens anzugeben.

Die Erfindung löst die Aufgabe für das Verfahren durch die im kennzeichnenden Teil des Anspruches 1 genannten Merkmale. Weiterbildungen des Verfahrens sind in den Unteransprüchen 2 bis 6 gekennzeichnet.

Die Überlagerung des Grundstromes mit einem pulsierenden Strom erfolgt dabei unabhängig von möglichen Welligkeiten des Grundstromes, die durch eine unvollkommene Glättung hervorgerufen werden.

Bei der Realisierung des erfindungsgemäßen Verfahrens wird ein überraschendes Ergebnis erzielt. Es wurde gefunden, daß nach Überlagerung des Grundstromes der zum stabilen Betrieb des Vakuumlichtbogenverdampfers erforderlich ist, mit einem pulsierenden Strom, der die angegebenen Parameter aufweist, der Grundstrom auf einen Wert abgesenkt werden kann, der unter dem Wert liegt, der ohne pulsierenden Strom zur Aufrechterhaltung einer stabilen Bogenentladung erforderlich ist. Der Grundstrom kann dabei soweit gesenkt werden, daß auch der mittlere Strom aus Grundstrom plus pulsierendem Strom unter dem Wert des Bogenstromes liegt, der bei üblichen Konstantstrombetrieb minimal erforderlich ist, um den Vakuumlichtbogen stabil zu betreiben. Als vorteilhaft wurden Stromabsenkungen zwischen 10 und 50 A ermittelt.

Bei hohen Anstiegsgeschwindigkeiten des Impulsstromes wurde auch ein erheblicher Anstieg der Bogenspannung über dem Target und der Anode festgestellt. Erst nach einer gewissen Zeit fällt die Bogenspannung wieder auf die üblichen Werte für eine Vakuumlichtbogenentladung bei ca. 20 V, in Abhängigkeit vom Targetmaterial und der Geometrie des Targets, ab. Das ist wahrscheinlich auch der Grund dafür, daß eine wesentliche Minderung bis nahe der Vermeidung der Dropletbildung bei der Realisierung des erfindungsgemäßen Verfahrens festgestellt wurde. Die erhöhte Bogenspannung in der Anstiegsphase des Impulsstromes bei relativ niedrigen Strömen führt zu einer Erhöhung der Ionisationsrate und auch zur Mehrfachionisation des verdampften Materials sowie damit zu haftfesteren Schichten.

Die Erodierung des Targetmaterials bei erhöhten Spannungswerten erfolgt unmittelbar aus der festen Phase in die Dampfphase. Nachdem die Spannungswerte nach einer gewissen Zeit, die von der Größe und der Form des Impulses, den Stromwerten und dem Targetmaterial abhängig ist, wieder den Normalwert einer Vakuumlichtbogenentladung erreicht haben, tritt der Prozeß wieder in die übliche Verdampfungsphase ein, soweit der Grundstrom zur Aufrechterhaltung des Bogens ausreicht. Durch die überlagerung des Grundstromes mit dem pulsierenden Strom, bei ausreichender Frequenz und Amplitude, kann in einfacher Weise die übliche Verdampfung auch bei höheren mittleren Spannungen erfolgen.

Die Parameter des pulsierenden Stromes können in den angegebenen Bereichen in weiten Grenzen variiert werden. Durch vorteilhafte Wahl der Parameter des pulsierenden Stromes kann die Verdampfungsleistung höher eingestellt werden als bei bekannten Lösungen, wobei die Dropletbildung weitgehend vermieden wird. Die Erfindung ermöglicht Strommittelwerte bis 200 A bei minimaler Dropletbildung.

Die angegebenen außerordentlich hohen Stromwerte des pulsierenden Stromes bis 5000 A werden mit Kondensatorentladungen erzielt, d.h. mit nadelförmigen Impulsen, und führen zu hohen Verdampfungsleistungen.

Ein besonderer Vorteil der Erfindung besteht darin, daß die Verdampfungsleistung eines Vakuumlichtbogenverdampfers über einen vergleichsweise breiten Arbeitsbereich eingestellt werden kann. Dabei ist festzustellen, daß die Lage des Kathodenfleckes bei unverändert stochastischer Bewegung mit hohen Stromwerten tendenziell an den Rand des Targets getrieben werden kann, während der Kathodenfleck bei niedrigen Stromwerten tendenziell das Zentrum des Targets ansteuert.

Auf dieser Grundlage kann durch geeignete Wahl der Parameter des pulsierenden Stroms, der Amplitude, die Form des Impulses und die Frequenz sowie durch Variation dieser Parameter während der Verdampfung, gezielt das innere oder äußere Targetmaterial verdampft werden. Mit einfachen Mitteln ist es möglich, die Oberfläche des Targets sehr gleichmäßig abzutragen und das Target nahezu vollständig auszunutzen. Reste müssen praktisch nur verbleiben, damit nicht die Halterung des Targets verdampft wird. Der erfindungsgemäße Vakuumlichtbogenverdampfer ermöglicht bei Einsatz eines Targets mit unterschiedlichen Materialien in konzentrischer Anordnung nur durch Vorgaben und Variation der Parameter des pulsierenden Stromes, zwei Materialien mit wechselndem Mischungsverhältnis oder mehrlagig abzuscheiden.

Die Aufgabe der Erfindung bezüglich einer Einrichtung zur Durchführung des Verfahrens wird durch die Merkmale im kennzeichnenden Teil des Anspruches 7 gelöst.

In einer vorteilhaften Ausgestaltung ist die Stromversorgungseinrichtung für den Vakuumlichtbogenverdampfer an einen Mikrorechner angeschlossen, der variable Pulsmuster erzeugt und über die Zahl der Impulse die Abscheidung bestimmter Schichten, insbesondere nach Dicke oder bei mehreren Materialien auch nach dem Mischungsverhältnis, regelt. Durch die Wahl entsprechender Parameter des Impulsstromes und die Zahl der Impulse kann eine bestimmte Menge eines Materials oder variable Materialmengen verschiedener koaxial angeordneter Materialien verdampft und als äquivalente Schicht abgeschieden werden. Konkrete Anwendungen sind in den Ausführungsbeispielen angegeben.

Mit dem Verfahren und der Einrichtung zur Realisierung des Verfahrens können bei relativ geringem technischen Aufwand Einfach-, Mehrfach- und/oder Mischschichten hergestellt werden, die eine hohe Dichte und gute Schichthomogenität aufweisen. Dabei ist der Energieeinsatz relativ niedrig und die Targetausnutzung sehr hoch.

Nachfolgend wird die Erfindung an zwei Ausführungsbeispielen näher erläutert.

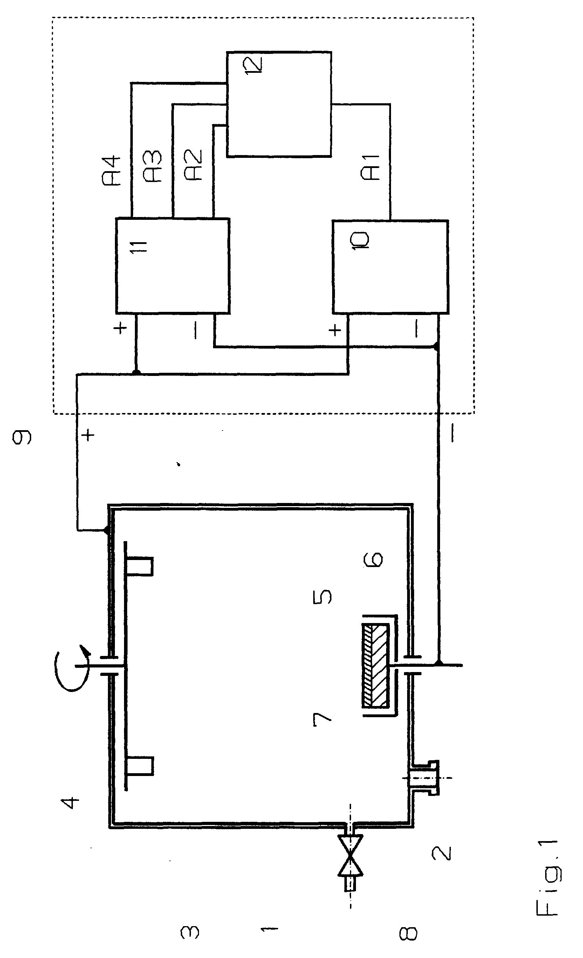

Die zugehörige Zeichnung zeigt in Fig. 1 eine als solche bekannte Beschichtungseinrichtung mit einem Vakuumlichtbogenverdampfer und ein Schaltschema für die Stromversorgung des Vakuumlichtbogenverdampfers.
Fig. 2 zeigt ein Diagramm des Verdampfungsstromes.
Fig. 3 zeigt vergleichend die Targetabtragung nach dem Stand der Technik (a) und der Erfindung (b). Fig. 4 zeigt den Strom- und Spannungsverlauf bei einem gepulsten Stromverlauf. Fig. 5 zeigt ein Target mit zwei koaxial angeordneten Verdampfungsmaterialien.

Beispiel I

Im Beispiel I sollen Schneidwerkzeuge mit einer Hartstoffschicht aus Titannitrid (TiN) beschichtet werden.

Die verwendete Beschichtungseinrichtung ist in Fig.1 dargestellt. In bekannter Weise besteht die Beschichtungseinrichtung aus einer Vakuumkammer 1, die über einen Flansch 2 durch ein Vakuumpumpsystem evakuiert wird. Die zu beschichtenden Substrate 3 sind an einem Drehkorb 4 fixiert. Im unteren Teil der Vakuumkammer 1 ist ein Vakuumlichtbogenverdampfer 5 angeordnet. Er besteht im wesentlichen aus einem wassergekühlten Grundkörper 6 und einem katodischen Target 7. über ein Regelventil 8 wird Reaktivgas, im Beispiel Stickstoff, eingelassen werden.

Das katodische Target 7 ist über den Grundkörper 6 mit dem negativen Pol der erfindungsgemäßen Stromversorgungseinrichtung 9 verbunden. Der positive Pol der Stromversorgungseinrichtung 9 ist mit der metallischen Vakuumkammer 1 verbunden.

Die Stromversorgungseinrichtung 9 besteht im wesentlichen aus einer Gleichstromquelle 10 als Quelle für den Grundstrom, einer Pulsstromquelle 11 als Quelle für den pulsierenden Strom sowie einer Steuereinrichtung 12. Die Gleichstromquelle 10 und die Pulsstromquelle 11 sind innerhalb der Stromversorgungseinrichtung 9 parallel geschaltet. Die nur schematisch dargestellte Steuereinrichtung 12 steuert über den Anschluß Al die Gleichstromquelle 10 und über die Anschlüsse A2, A3 und A4 die Pulsstromquelle 11. Dabei entsprechen die Anschlüsse A2, A3 und A4 Steuerleitungen, die die Amplitude, die Frequenz und die Pulslänge des Pulsstromes steuern. In die Steuereinrichtung 12 ist ein Mikrorechner integriert.

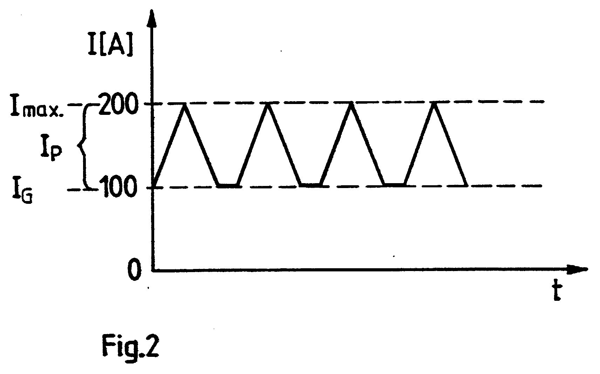

Mit dieser Einrichtung sollen im Beispiel I mit dem erfindungsgemäßen Verfahren TiN-Schichten, z. B. als Verschleißschutzschichten auf Schneidwerkzeugen, abgeschieden werden. Dazu wird als Target 7 hochreines Titan eingesetzt. Nach dem Zünden der Vakuumlichtbogenentladung durch einen hier nicht dargestellten Zündmechanismus wird ein Stromverlauf gemäß Fig. 2 über die Stromversorgungseinrichtung 9 eingestellt.

Der Grundstrom $I_G$ = 100 A ist mit einem dreieckförmigen pulsierenden Strom $I_P$ überlagert, so daß der Spitzenwert $I_{max} = I_G + I_P$ = 200 A beträgt. Die Pulsfolgefrequenz wird im Beispiel auf 5 kHz eingestellt. Die Steuerung der Grundstromquelle 10 und der Pulsstromquelle 11 erfolgt über die Steuereinrichtung 12.

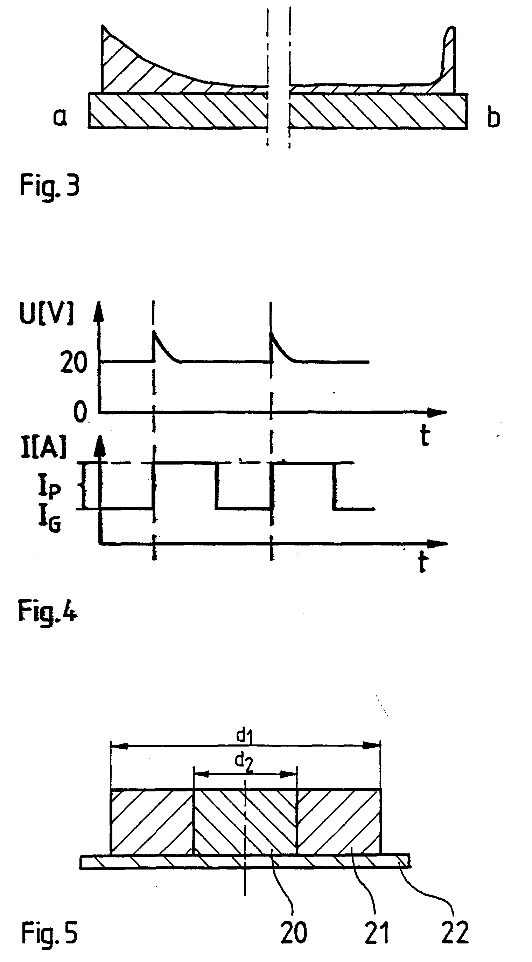

Für jede gewünschte Verdampferleistung stellt die Steuereinrichtung 12 ein spezielles Pulsmuster bereit, mit dem ein gleichmäßiger Targetabbrand gesichert wird. In Fig. 3 b ist die Targetausnutzung bei Einsatz des erfindungsgemäßen Verfahrens nach mehrstündiger Betriebszeit dargestellt. Die Targetausnutzung beträgt bis 90% des Targetmaterials. Der Abbrand des Targets erfolgt eben bis auf einen schmalen Randbereich.

In Fig. 3 a ist die Targetausnutzung bei einer vergleichsweisen DC-Vakuumlichtbogenentladung nach dem Stand der Technik dargestellt, diese beträgt nur etwa 60% des Targetmaterials.

Wie bereits in der Beschreibung dieser Erfindung dargelegt wurde, liegt die Ursache für die verbesserte Targetausnutzung darin, daß der Kathodenfleck bei höheren Strömen, d. h. wenn der Impulsstrom $I_P$ sein Maximum erreicht, nach außen wandert, während der Kathodenfleck bei $I = I_G$ nach innen wandert. Bei oft hohen Targetkosten können somit erhebliche Materialkosten eingespart werden.

Die Verdampferrate, besser Erosionsrate, ist dem zeitlichen Mittel des Stromes proportional und wird aus

$$\bar{I} = \frac{1}{T} \int (I_G + I_P(t)) \, dt$$

berechnet. Dabei konnte überraschend festgestellt werden, daß $\bar{I}$ und damit auch die Erosionsrate in einem sehr weiten Bereich gestellt werden kann. Während bei der DC-Vakuumlichtbogenentladung nach dem Stand der Technik der Vakuumlichtbogen unterhalb 80 A erlischt und bei größer 120 A eine vermehrte Dropletemission auftritt, kann mit der Erfindung die Vakuumlichtbogenentladung im Bereich eines mittleren Stromes $\bar{I}$ von 65 A bis 150 A betrieben werden, ohne daß einerseits der Vakuumlichtbogen erlischt und andererseits eine unzulässige Dropletemission erreicht wird. Dabei beziehen sich die angegebenen Werte jeweils auf die gleiche Beschichtungseinrichtung. Bei einer anderen Target-Beschichtungskammer-Geometrie können sich die Betriebsparameter auch etwas verschieben.

Mit dem erfindungsgemäßen Verfahren ist es möglich, höhere Ionisierungsenergien umzusetzen und in der Folge eine bessere Haftfestigkeit der Schicht auf dem Substrat zu erreichen.

In Fig. 4 ist der Strom- und Spannungsverlauf bei einem rechteckigen Pulsmuster dargestellt. Bei $I = I_G$ stellt sich wie beim Stand der Technik ein typischer Spannungsabfall über der Vakuumlichtbogenentladung von 20 V ein. Bei Überlagerung des Grundstromes $I_G$ mit einem pulsierenden Strom $I_P$, z. B. auf $I = I_G + I_P = 80\ A + 50\ A = 130\ A$, erhöht sich schlagartig auch der Spannungsabfall über der Lichtbogenentladung. Die Überhöhung des Spannungsabfalls zu Beginn des Stromimpulses führt zu einer höheren Ionisierung und zur Mehrfachionisation des Metalldampfes. Die höheren Ionisierungsenergien führen in der Folge zu einer besseren Haftfestigkeit der abgeschiedenen Schichten auf den Substraten 3.

Des weiteren führt dieser Effekt auch zu einer wesentlichen Minderung der Dropletbildung und somit zu einer störungsfreien Schichtausbildung auf dem Substrat 3.

Beispiel II

Der besondere Vorteil der Erfindung stellt sich bei der Abscheidung von Misch- und Mehrfachschichten ein. Im Beispiel II sollen in äquivalenter Weise wie in Beispiel I Schneidwerkzeuge mit einer Hartstoffschicht beschichtet werden, wobei als Hartstoffschicht eine $Ti_xAl_yN_z$-Schicht ausgebildet werden soll.

Als Target wird das in Fig. 5 dargestellte rotationssymmetrische Target, welches koaxial einen inneren Pfropfen 20 aus Aluminium und einen äußeren Ring 21 aus Titan aufweist, eingesetzt. Die Targethalterung 22 ist nur schematisch angedeutet. Es wird ein Durchmesserverhältnis $d_2 = 0{,}7 \times d_1$ gewählt. Das entspricht beispielsweise etwa $d_1 = 65$ mm und $d_2 = 45$ mm. Der Herstellungsaufwand einer derartigen konzentrischen Anordnung von zwei Materialien ist im Vergleich zum Stand der Technik wesentlich geringer. Besonders gegenüber der Verwendung von metallischen oder sintermetallischen Mischtargets ist der ökonomische Vorteil signifikant.

Die Verdampfung des Targets, bestehend aus Aluminium und Titan, kann in weiten Bereichen variiert werden. Durch Veränderung des Verhältnisses $I_P : I_G$ und/oder durch die Pulslänge kann die Materialzusammensetzung der abgeschiedenen Schicht Ti:Al von 5:1 bis 2:5 variiert werden.

Mit nur einem Vakuumlichtbogenverdampfer können somit Schichten unterschiedlicher Stöchiometrie oder Mehrfachschichten abgeschieden werden.

Im Beispiel II wird zur Abscheidung einer Hartstoffschicht aus $Ti_xAl_yN_z$ in einer Sickstoffatmosphäre in den ersten Atomlagen eine Schicht mit einem höheren Al-Gehalt abgeschieden, um eine gute Korrosionsschutzwirkung zu gewährleisten, und im oberen Teil der Funktionsschicht wird, zur Erzielung einer entsprechenden Härte, die Stöchiometrie der abgeschiedenen Schicht entsprechend optimiert.

**Patentansprüche**

1. Verfahren zum Betreiben eines Vakuumlichtbogenverdampfers, der aus einem katodischen Target, einer Anode, einem Zündmechanismus und einer Gleichstromquelle besteht, wobei zwischen dem kathodischen Target und der Anode mittels des Zündmechanismus bei ausreichender Spannungsdifferenz und Stromversorgung ein Vakuumlichtbogen gezündet wird, der im wesentlichen im Plasma des dabei verdampften Materials selbständig weiterbrennt, **dadurch gekennzeichnet**, daß einem Grundstrom, der zum stabilen Betrieb des Vakuumlichtbogenverdampfers erforderlich ist, ein pulsierender Strom überlagert wird, dessen Frequenz mindestens 1 Hz und die Amplitude mindestens 10 A beträgt.

2. Verfahren nach Anspruch 1, **dadurch gekennzeichnet**, daß der Grundstrom nach der Überlagerung mit dem pulsierenden Strom vorzugsweise um 10 bis 50 A unter den Wert des Stromes gesenkt wird, der nach der Zündung des Vakuumlichtbogens zur Aufrechterhaltung einer stabilen Bogenentladung ohne pulsierenden Strom minimal erforderlich ist.

3. Verfahren nach Anspruch 1, **dadurch gekennzeichnet**, daß der pulsierende Strom nadel-, rechteck-, dreieck- oder sinusförmig moduliert wird.

4. Verfahren nach Anspruch 1, **dadurch gekennzeichnet**, daß die Frequenz und/oder die Amplitude und/oder die Pulslänge des pulsierenden Stromes während des Betriebes des Vakuumlichtbogenverdampfers verändert wird.

5. Verfahren nach Anspruch 4, **dadurch gekennzeichnet**, daß die Frequenz im Bereich zwischen 100 Hz und 50 kHz gewählt und/oder die Amplitude des pulsierenden Stromes im Bereich zwischen 10 und 5000 A und/oder die Pulslänge zwischen 10 ms bis 20 us geregelt wird.

6. Verfahren nach Anspruch 1, **dadurch gekennzeichnet**, daß bei einem Target aus einem Material oder aus unterschiedlichen Materialien in konzentrischer Anordnung die Amplitude des pulsierenden Stromes und/oder die Pulslänge zum Verdampfen des äußeren Materials erhöht und zum Verdampfen des inneren Materials gesenkt wird.

7. Stromversorgungseinrichtung zum Betreiben eines Vakuumlichtbogenverdampfers bestehend aus einem katodischen Target, einer Anode und einer Gleichstromquelle nach dem Verfahren gemäß einem der Ansprüche 1 bis 6, **dadurch gekennzeichnet**, daß der Gleichspannungsquelle eine Pulsstromquelle parallel geschaltet ist, die Mittel zur Erzeugung zyklischer Kondensatorentladungen aufweist.

## Claims

1. Method for operating a vacuum arc vaporizer which comprises a cathodic target, an anode, an ignition mechanism and a DC source, a vacuum arc being struck between the cathodic target and the anode by means of the ignition mechanism when the voltage difference and the power supply are adequate, which vacuum arc essentially continues to burn autonomously in the plasma of the material which is vaporized in the process, characterized in that a basic current which is required for stable operation of the vacuum arc vaporizer has superimposed on it a pulsating current whose frequency is at least 1 Hz and whose amplitude is at least 10 A.

2. Method according to Claim 1, characterized in that, after superimposition of the pulsating current of, preferably, 10 to 50 A, the basic current is reduced below the level of the current which is required as a minimum after striking of the vacuum arc in order to maintain a stable arc discharge without a pulsating current.

3. Method according to Claim 1, characterized in that the pulsating current is modulated in the form of needlepoints, square waves, triangular waves or sinusoidally.

4. Method according to Claim 1, characterized in that the frequency and/or the amplitude and/or the pulse length of the pulsating current is varied during the operation of the vacuum arc vaporizer.

5. Method according to Claim 4, characterized in that the frequency is chosen to be in the range between 100 Hz and 50 kHz, and/or the amplitude of the pulsating current is controlled in the range between 10 and 5000 A, and/or the pulse length is controlled between 10 ms to 20 μs.

6. Method according to Claim 1, characterized in that, if a target is composed of a material or of different materials arranged concentrically, the amplitude of the pulsating current and/or the pulse length are/is increased to vaporize the outer material and are/is reduced to vaporize the inner material.

7. Power supply device for operating a vacuum arc vaporizer comprising a cathodic target, an anode and a DC source in accordance with the method according to one of Claims 1 to 6, characterized in that the DC voltage source has connected in parallel with it a pulsed-current source which has means for producing cyclic capacitor discharges.

## Revendications

1. Méthode pour le fonctionnement d'un évaporateur à arc sous vide, constitué d'une cible cathodique, d'une anode, d'un mécanisme d'amorçage et d'une source de courant continu, un arc électrique sous vide étant amorcé entre la cible cathodique et l'anode au moyen du mécanisme d'amorçage lorsque la différence de tension et l'alimentation électrique sont suffisantes, cet arc étant intrinsèquement auto-entretenu dans le plasma du matériau vaporisé, caractérisée en ce qu'à un courant de base nécessaire au fonctionnement stable de l'évaporateur à arc sous vide est superposé un courant pulsé dont la fréquence est d'au moins 1 Hz et l'amplitude d'au moins 10 A.

2. Méthode selon la revendication 1, caractérisée en ce qu'après superposition du courant pulsé, le courant de base est abaissé de préférence de 10 à 50 A au-dessous de la valeur du courant minimal nécessaire pour le maintien d'une décharge stable de l'arc sans courant pulsé après l'amorçage de l'arc électrique sous vide.

3. Méthode selon la revendication 1, caractérisée en ce que le courant pulsé est modulé par des signaux en forme de pics, rectangulaires, triangulaires ou sinusoïdaux.

4. Méthode selon la revendication 1, caractérisée en ce que la fréquence, et/ou l'amplitude et/ou la durée des impulsions du courant pulsé est modifiée pendant le fonctionnement de l'évaporateur à arc sous vide.

5. Méthode selon la revendication 4, caractérisée en ce que la fréquence est choisie dans la plage entre 100 Hz et 50 kHz et/ou l'amplitude du courant pulsé est réglée dans la plage entre 10 et 5000 A et/ou la durée des impulsions est réglée de 10 ms à 20 µs.

6. Méthode selon la revendication 1, caractérisée en ce qu'avec une cible constituée d'un matériau ou de divers matériaux disposés de manière concentrique, l'amplitude du courant pulsé et/ou la durée des impulsions est augmentée pour vaporiser le matériau externe et est abaissée pour vaporiser le matériau interne.

7. Equipement d'alimentation électrique pour le fonctionnement d'un évaporateur à arc sous vide, constitué d'une cible cathodique, d'une anode et d'une source de courant continu d'après la méthode selon l'une des revendications 1 à 6, caractérisé en ce que la source de tension continue est branchée en parallèle avec une source de courant pulsée qui comporte des moyens pour générer des décharges cycliques de condensateur.

Fig.1

Fig.2

**Fig. 3**

**Fig. 4**

**Fig. 5**

20   21   22